Europäisches Patentamt

European Patent Office

Office européen des brevets

(19)

(11) **EP 1 120 437 A1**

(12) **EUROPEAN PATENT APPLICATION**

(43) Date of publication:
01.08.2001 Bulletin 2001/31

(51) Int Cl.⁷: **C08J 5/18**, C08G 75/02

(21) Application number: 01101381.0

(22) Date of filing: 22.01.2001

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: 25.01.2000 JP 2000015635<br><br>(71) Applicant: **TORAY INDUSTRIES, INC.**<br>**Tokyo 103-8666 (JP)** | (72) Inventors:<br>• **Tsunashima, Kenji**<br>  **Kyoto-shi, Kyoto 607-8075 (JP)**<br>• **Machida, Tetsuya**<br>  **Otsu-shi, Shiga 520-0842 (JP)**<br>• **Sakamoto, Jun**<br>  **Otsu-shi, Shiga 520-0842 (JP)**<br><br>(74) Representative: **Kador & Partner**<br>**Corneliusstrasse 15**<br>**80469 München (DE)** |

(54) **Polyphenylene sulfide film, method for producing the same, and circuit board using the same**

(57)  A polyphenylene sulfide film has a heat distortion temperature of 200°C or more. The polyphenylene sulfide film of the present invention has superior soldering heat resistance, dimensional stability to heat, low hygroscopicity, fire retardance, and high-frequency properties, and also the polyphenylene sulfide film is suitable for use as an insulating substrate which has superior processability in a circuit board.

EP 1 120 437 A1

Printed by Jouve, 75001 PARIS (FR)

**Description**

BACKGROUND OF THE INVENTION

1. Field of the Invention

The present invention relates to a polyphenylene sulfide film having a superior degree of heat resistance, the heat resistance being equal to or greater than that of a polyimide resin film or a liquid crystalline resin film, relates to a method for producing the same, and relates to a circuit board using the polyphenylene sulfide film as a substrate thereof.

2. Description of the Related Art

As heat-resistant films, films formed of polyimide resins or liquid-crystalline resins are well known. Such resins have high heat resistance, low coefficients of thermal expansion, excellent insulating properties, low hygroscopicity, excellent gas barrier properties, and high strength, and have been practically used for injection-molded articles, fibers, films, etc. Printed-wiring boards for ICs using these resins have also been developed and are in practical use. Thus, heat-resistant films are being advantageously used in the fields of electrical and electronic components.

In the fields of electrical and electronic components, in view of miniaturization and increases in performance of apparatuses, there are increased demands for insulating substrates in which various characteristics, such as soldering heat resistance, high dimensional stability to heat as well as to moisture, low hygroscopicity, and high-frequency properties, are well balanced at high levels.

Examples of the conventional circuit boards (wiring boards) used as components for electrical, electronic apparatuses include substrates in which the heat-resistant films and glass cloths are impregnated with epoxy resins (hereinafter referred to as "glass-epoxy substrates"), and substrates in which fluorine-containing films and glass cloths are impregnated with fluorine-containing resins. Circuit boards in which polyphenylene sulfide (hereinafter referred to as "PPS") is used as substrates have also been proposed. Specifically, as a circuit board using PPS as the substrate, for example, a fiber sheet composed of a resin composition containing a fibrous material and PPS as principal ingredients is disclosed in Japanese Unexamined Patent Application Publication No. 5-310957.

However, the conventional substrate materials described above have some drawbacks as described below. Polyimide resin films have inferior dimensional stability to moisture, and since dimensions changes greatly at high humidity, there are limitations to the use thereof in printed-wiring boards for ICs, which are easily affected by dimensional changes. Although liquid-crystalline resin films have superior dimensional stability to moisture, since they are thermoplastic resins, they have inferior soldering heat resistance, i.e., the liquid-crystalline resin films are melted by hot solder. With respect to glass-epoxy substrates, because of inferior high-frequency properties and inferior hygroscopic properties, as frequencies increase, dielectric properties are degraded, and also since a laser method cannot be used to form through-holes, there are limitations to machining precision. With respect to substrates in which fluorine-containing films and glass cloths are impregnated with fluorine-containing resins, paste and plating are not easily applied during printing and the deposition of metal films and are not easily applied during the formation of through-holes during the fabrication of circuits.

With respect to PPS films, although non-oriented sheets have satisfactory characteristics, such as low hygroscopicity, fire retardance, and high-frequency properties, the heat resistance thereof is insufficient in comparison with that of biaxially oriented films, and as the number of fabrication steps is increased, crystallization progresses, resulting in brittleness. When the crystal size, etc., are controlled, the heat resistance and brittleness are improved. However, thermal deformation easily occurs when heat is rapidly applied, as is the case in soldering.

Biaxially oriented PPS films exhibit large degrees of heat shrinkage, and for example, if heat is applied in the fabrication process of circuit boards, the films are deformed due to heat shrinkage, and misalignment easily occurs in the circuits. Therefore, although the heat shrinkage may be reduced by annealing treatment or the like, if the heat shrinkage at 250°C is specified to be 1% or less, the surface flatness of the films is significantly degraded.

With respect to a sheet in which a PPS resin is impregnated into a fibrous material, such as a glass cloth, although superior heat resistance, dimensional stability to heat, hygroscopicity, and high-frequency properties are exhibited, if a force, such as a bending force, is applied, cracking may occur, and such a sheet also has inferior thermal bonding properties, thus giving rise to problems in the manufacture of circuit boards. In particular, the applications thereof are limited in the fields in which thermal bonding properties and decreases in thickness are required.

The present invention has been made to overcome the drawbacks associated with the conventional films. It is an object of the present invention to provide a film having a low coefficient of thermal expansion and a low coefficient of hygroscopic expansion, and which also has a high level of heat resistance, i.e., to provide a PPS film suitable for use as an insulating substrate which has superior processability as a circuit board, the insulating substrate having characteristics such as heat resistance, dimensional stability to heat, thermal bonding processability, and through-hole processability, by making effective use of the superior high-frequency properties, low hygroscopicity, and fire retardance of PPS while maintaining the surface properties of the film. It is another object of the present invention to provide a method for producing such a PPS film and to provide a circuit board using the PPS film.

SUMMARY OF THE INVENTION

The present inventors have conducted extensive research and have found that the problems described above can be solved by a heat-treated polyphenylene sulfide film, thus achieving the present invention.

That is, in accordance with the present invention, (1) a polyphenylene sulfide film has a heat distortion temperature of 200°C or more; and (2) a polyphenylene sulfide film is composed of a polyphenylene sulfide resin, and has a heat shrinkage of 0.05% or less at 200°C over 5 minutes in all directions in the film.

In accordance with the present invention, a circuit board includes the polyphenylene sulfide film described above in which an electrical circuit is provided at least on one surface thereof.

In accordance with the present invention, (1) a method for producing a polyphenylene sulfide film includes the step of heat-treating a polyphenylene sulfide film having a heat distortion temperature of 150°C or less so as to increase the heat distortion temperature to 200°C or more; and (2) a method for producing a polyphenylene sulfide film includes the step of heat-treating a polyphenylene sulfide film composed of a single layer or multiple layers in the temperature range of 200°C to 350°C for 5 minutes to 10 hours.

Preferably, the polyphenylene sulfide film has a heat distortion temperature of 285°C or more, a coefficient $\alpha$ of thermal expansion of 20 ($\times$ 10$^{-6}$/°C) or less, a coefficient $\beta$ of hygroscopic expansion of 5 ($\times$ 10$^{-6}$/%RH) or less, and a soldering heat resistance of 290°C or more.

DESCRIPTION OF THE PREFERRED EMBODIMENTS

A polyphenylene sulfide film of the present invention is basically composed of a polyphenylene sulfide (PPS) resin.

The polyphenylene sulfide resin in the present invention is a resin containing poly-para-phenylene sulfide in an amount of, preferably, 70 mole % or more, and more preferably, 80 mole % or more. If the content of poly-para-phenylene sulfide is less than 70 mole %, the crystallinity and melting point of the polymer are decreased, and thus various characteristics, such as heat resistance, dimensional stability, mechanical properties, low hygroscopicity, fire retardance, and high-frequency properties, may be degraded.

In the PPS resin, a unit containing another polymerizable sulfide bond may be included as long as the amount thereof is less than 30 mole % of the repeating unit, and preferably less than 20 mole %. Specific examples of the unit in the amount of less than 30 mole % or preferably, less than 20 mole % of the repeating unit, are a trifunctional unit, an ether unit, a sulfone unit, a ketone unit, a meta-bond unit, an aryl unit having a substituent, such as an alkyl group, a biphenyl unit, a vinylene unit, and a carbonate unit, and at least one of the above units may be included. In such a case, the structural unit may be either random-copolymerized or block-copolymerized.

The PPS resin is preferably a linear high polymer having a molecular weight of 50,000 or more. However, the present invention is not necessarily limited to this, and the PPS resin may be a high polymer having branched chains, or a high polymer partially including a cross-linked structure.

With respect to a method for producing such PPS resins, methods as disclosed in U.S. Pat. No. 3,354,129, etc., may be mentioned.

In the present invention, by using PPS which is preliminarily cross-linked and polymerized by heating as a PPS resin, it is possible to decrease the heat-treating period of the film, thus achieving objects of the present invention. Examples of the specific method for cross-linking and polymerizing the PPS resin include a method in which heating is performed, in an atmosphere containing an oxidizing gas, such as air or oxygen, or in an atmosphere containing a mixture of an oxidizing gas and an inert gas (such as nitrogen or argon) in a heating vessel at a predetermined temperature until the desired melting viscosity is obtained. The heat-treating temperature is usually set at 170 to 280°C, and preferably at 200 to 270°C, and the heat-treating period is usually set at 0.5 to 100 hours, and preferably at 2 to 50 hours. It is possible to obtain the desired viscosity by controlling the above two factors. However, when the PPS material before film formation is cross-linked and polymerized, if the degree of cross-linking and the molecular weight are excessively increased, it becomes difficult to perform melt molding, and therefore it is not possible to obtain the polyphenylene sulfide film of the present invention merely by the use of a material having a high degree of cross-linking and a high molecular weight.

The PPS resin may contain a low-molecular weight oligomer. The low-molecular weight oligomer has a molecular-weight distribution having a range of 100 to 2,000, and the low-molecular weight oligomer contained in the PPS resin can be removed by cleaning with a solvent, such as diphenyl ether. In the present invention, the amount of oligomer extracted by treatment in boiling xylene for 36 hours is preferably set at 1.5% by weight or less.

In the present invention, the PPS resin may be used alone or may be used as a polymer alloy. Examples of alloying polymers are polyesters, liquid-crystalline polyesters, polyamides, polyolefins, polyimides, polyamide-imides, polyetherimides, polyarylates, modified polyphenylene sulfides, polyether ether ketones, polyether sulfones, and polysulfones. However, the alloying polymer used in the present invention is not limited thereto. Preferably, the mixing ratio of the alloying polymer to the PPS resin is approximately 0.1 to 30% by weight.

The polyphenylene sulfide film of the present invention has a heat distortion temperature of 200°C or more, which is a feature of the invention, and is useful.

That is, the conventional PPS resin film has a heat distortion temperature of approximately 90°C, which is in the vicinity of the glass transition temperature (Tg) thereof, and even if the film is oriented, the heat distortion temperature remains substantially the same at approximately 90°C.

In contrast, the feature of the polyphenylene sulfide film of the present invention is that the heat distortion temperature is increased to be 200°C or more, and preferably to 260°C or more.

That is, when soldering is performed in the fabrication process of an IC substrate or the like, the surface temperature of a soldering iron reaches 250°C or more, and in some cases, 300°C or more. When a soldering iron at such a high temperature is briefly brought into contact with the IC substrate film, if the substrate film deforms due to melting, the substrate film is not suitable for use in various applications, such as for IC substrates. However, the polyphenylene sulfide film of the present invention can be used in such applications.

In the polyphenylene sulfide film of the present invention, the upper limit of the heat distortion temperature is preferably approximately 350°C, and more preferably, approximately 320°C, according to tests by the present inventors. If the heat distortion temperature exceeds 350°C, the degree of cross-linking is believed to be significantly increased. However, the PPS film then becomes very brittle.

In addition to the above, the present invention is useful in that the polyphenylene sulfide film displays the physical properties described above and also maintains the useful form of a film.

That is, although the conventional technique makes it possible to cross-link a PPS resin material by oxidation so that the resultant PPS resin has a heat distortion temperature of 200°C or more. However, in a resin which is cross-linked by such a conventional technique, moldability, such as melt extrudability and fluidity, are significantly inferior, and it is not possible to obtain a homogeneous film.. Even if a non-oriented film or the like is obtained, it is impossible to perform stretch molding, and with respect to the physical properties of the non-oriented film or a slightly oriented film, the breaking elongation is less than 20%, and in typical cases, is less than 10%, and thus such films are too brittle for practical use.

In contrast, the polyphenylene sulfide film of the present invention has a small thermal deformation rate at a high temperature of 250 to 280°C. Therefore, while the conventional biaxially oriented PPS film has a very large thermal deformation rate, i.e., a heat shrinkage rate, of approximately 5 to 15%, at 250°C, the PPS film of the present invention, which is cross-linked by heating, usually has a thermal deformation rate-of 3% or less, and preferably 0 to 2%.

The polyphenylene sulfide film of the present invention also has a breaking elongation of, preferably 10% or more, and more preferably, approximately 20 to 50%, and a breaking strength of approximately 100 to 250 MPa, as mechanical properties.

The polyphenylene sulfide film of the present invention has a coefficient $\alpha$ of thermal expansion of, preferably 30 ($\times$ 10$^{-6}$/°C) or less, and more preferably, 20 ($\times$ 10$^{-6}$/°C) or less. Therefore, the film has a substantially very small dimensional change due to high temperatures of approximately 80 to 200°C.

Consequently, when the polyphenylene sulfide film of the present invention is used, for example, for a substrate film in which a copper foil and the polyphenylene sulfide film are bonded to each other, curling does not occur due to heat treatment during the bonding step of the copper foil, and also deformation does not substantially occur during the soldering step of electronic components, and thus the yield of circuit boards is improved.

Furthermore, the polyphenylene sulfide film of the present invention has a coefficient $\beta$ of hygroscopic expansion of, preferably 10 ($\times$ 10$^{-6}$/%RH) or less, and more preferably, 5 ($\times$ 10$^{-6}$/%RH) or less. When the polyphenylene sulfide film of the present invention with the coefficient $\beta$ of hygroscopic expansion in the range described above is used, even if it is used as a substrate film, it is possible to prevent the circuit pattern from deforming or the like due to a change in humidity in the operational environment.

The PPS film of the present invention has a soldering heat resistance of 250°C or more, preferably 260°C or more, and more preferably, 290°C or more. If the soldering heat resistance is less than 250°C, deformation or warpage may occur in the soldering process. In view of toxicity of lead, use of lead-free solders has been implemented, and since lead-free solders have higher melting points than those of conventional solders by 30°C or more, the PPS film preferably has a soldering heat resistance of 290°C or more. Although the higher soldering heat resistance is more preferable, since the heat-treating temperature for the film is increased accordingly, the surface flatness of the film is degraded. Therefore, the practical upper limit of the soldering heat resistance is approximately 310°C.

In another PPS film of the present invention, the heat shrinkage at 200°C over 5 minutes must be 0.05% or less in all directions of the film. If the heat shrinkage at 200°C exceeds 0.05%, deformation and misalignment in circuits easily occur during the fabrication of circuit substrates. The smaller heat shrinkage is more preferable. Herein, the heat shrinkage is a value obtained by dividing an amount of dimensional change when a sample is subjected to aging at 200°C for 5 minutes by the length of the sample before aging, and is shown in percentage.

The polyphenylene sulfide film of the present invention can be favorably produced by heat-treating a biaxially oriented PPS film or a multi-layered film, such as the one in which a biaxially oriented film and a non-oriented film are laminated, composed of films having the same degree or different degrees of orientation. The film thus heat-treated can be used as a biaxially oriented PPS film alone, as a film in which one biaxially oriented PPS film is laminated with another biaxially oriented PPS film, or as a film in which a non-oriented PPS film is provided at least on one surface of a biaxially oriented PPS film. The heat treatment improves the soldering heat-resisting temperature of the PPS film, and decreases the heat shrinkage at 200°C. However, if a biaxially oriented PPS film is heat-treated, surface flatness is easily degraded due to heat shrinkage. Therefore, by restricting the film in the transverse direction and/or the longitudinal direction, the film is shrunk at a predetermined rate. On the other hand, if a film in which a non-oriented PPS film is provided at least on one surface of a biaxially oriented PPS film is heat-treated, it is possible to decrease the heat shrinkage while maintaining more satisfactory surface flatness of the film. In a three-layered PPS film in which a biaxially oriented PPS film is provided on each surface of a non-oriented PPS film as a core layer, more satisfactory surface flatness can be obtained, and in such a case, it is possible to perform heat treatment without restricting the film in the transverse direction and/or in the longitudinal direction.

As described above, if only the non-oriented PPS film is heat-treated, since the film is not oriented, it becomes very brittle, thus being unsuitable for use in circuit substrates which are used while being folded, or the like, and also since the film is not oriented, it takes a long time to perform heating treatment. In contrast, by forming a laminated film in which the non-oriented PPS film and the biaxially oriented PPS film are laminated to each other, it is possible to obtain a film which does not become brittle even by heat treatment and which has excellent surface flatness, soldering heat resistance, and low heat shrinkage.

Additionally, prior to the lamination of the PPS films, preferably, the surface of the non-oriented film and/or the biaxially oriented film composed of PPS is subjected to corona treatment, ultraviolet treatment, or plasma treatment, depending on the application thereof.

As for the method for laminating PPS films, for example, when a biaxially oriented PPS film is provided on each surface of a non-oriented PPS film, (1) the three films are thermally bonded at a high temperature and at a high pressure; (2) PPS is directly melt-extruded between the two biaxially oriented PPS films; or (3) an adhesive is applied on the bonding sides of the non-oriented PPS film or the biaxially oriented PPS films, and lamination is performed, using a roll press, a hot-plate press, or the like.

In the method (1) described above, thermal bonding can be performed at a temperature of 180°C to 270°C, at a pressure of 0.1 to 2 MPa, using a roll press, a hot-plate press, or the like. When three layers are laminated as in this case, a two-layered film may be formed first and a biaxially oriented PPS film is laminated on the side of the non-oriented PPS film in the two-layered film. Alternatively, the three layers may be laminated simultaneously. As described above, in the present invention, it is possible to form a multi-layered polyphenylene sulfide film in which polyphenylene sulfide films having the same degree or different degrees of orientation are laminated.

Although the PPS film of the present invention may be a biaxially oriented PPS film, the PPS film is preferably a laminated film in which at least one surface of a biaxially oriented PPS film is laminated with a non-oriented PPS film, and more preferably, the PPS film is a laminated film in which each surface of a non-oriented PPS film is laminated with a biaxially oriented PPS film. In the laminated film composed of the non-oriented PPS film and the biaxially oriented PPS film, the thickness of the non-oriented PPS film is preferably in the range of 20 to 90% of the thickness of the entire film in view of balancing the individual properties, and more preferably, in the range of 40 to 80%.

At least one layer in the PPS film of the present invention is preferably biaxially oriented, and the degree of orientation of the biaxially oriented PPS film is in the range of 0.07 to 1.0, and more preferably, in the range of 0.5 to 0.7. Herein, the degree of orientation corresponds to a degree of orientation measured by a wide angle X-ray diffraction method and measured from each direction of the through, edge, and end directions. The degree of orientation from either direction is preferably in the range of 0.07 to 1.0, and more preferably, in the range of 0.5 to 0.7. Herein, the degree of orientation measured from a certain direction is defined, when an X-ray plate photograph is taken by applying X-rays from that direction, by a ratio $I(\Phi = 30°)/I(\Phi = 0°C)$, where $I(\Phi = 0°)$ is the photographic density of the (200) face of the PPS crystal measured by scanning a microdensitometer along the equator in the radial direction, and $I(\Phi = 30°)$ is the photographic density along the direction of 30°. Accordingly, preferably, the non-oriented PPS film has a degree of orientation of less than 0.07. The smaller degree of orientation is preferable.

In a laminated film, differences in the degree of orientation of the individual layers can be found by a method in which a very thin piece is cut out from the film to obtain a cross section thereof, and differences in brightness caused by the different degrees of orientation of the individual layers are observed using polarized light. It is also possible to measure the differences in the degree of orientation of the individual layers by observing the Raman spectrum of the cross section of the film using polarized light to obtain intensity ratios of the Raman band in the individual measuring directions.

The PPS film of the present invention has a dimensional change rate at room temperature, preferably of 1% or less in all directions in the film when the temperature is increased from room temperature to 200°C and is then decreased to room temperature, and more preferably of 0.3% or less. If the dimensional change rate exceeds 1%, misalignment in circuits occurs in the mounting process of the component, resulting in a decrease in the yield.

Herein, the dimensional change rate is measured by a thermal-mechanical analysis (TMA), in which a sample with a width of 4 mm and an initial length of 15 mm is heated from room temperature to 200°C, under a load of 4.67 g/mm$^2$ and at a heating rate of 20°C/minute, and then is cooled to room temperature under the same conditions, the amount of dimensional change is divided by the initial length, and the resultant value is shown in percentage. Herein, the room temperature is defined as 23°C $\pm$ 2°C.

In the PPS film of the present invention, the endothermic peak ($T_{meta}$) according to differential scanning calorimetry (DSC) is equal to or less than the melting point ($T_m$) and is equal to or more than ($T_m$-80)°C, and more preferably, is equal to or more than ($T_m$ - 70)°C. The endothermic peak ($T_{meta}$) corresponds to the heat-treating temperature of the film, and is observed as a minute peak, which is caused because imperfect portions in the crystal structure formed by the heat treatment are melted. Therefore, two or more endothermic peaks may be present.

A method for producing a special PPS film in the present invention will be described.

That is, by using a typical polyphenylene sulfide film having a heat distortion temperature of 150°C or less, for example, a film in which crystals before treatment have a heat of fusion $\Delta H_1$ of 35 J/g or more, or a multi-layered film in which such a biaxially oriented PPS film and a non-oriented PPS film are laminated, or using a film having a heat distortion temperature of approximately 90°C, heat treatment is performed, in an oxygen atmosphere, at 200 to 350°C, which is close to the melting point of PPS, for 5 minutes to 10 hours to effect cross-linking so that the heat distortion temperature is increased to 200°C.

In the method described above, as the heat-treating period is increased, cross-linking by oxidation progresses, and therefore the heat distortion temperature of the resultant film is increased. Although heat-treating may be performed in one step, since the film before heat treatment does not have a high degree of heat resistance, heat treatment at high temperatures is preferably performed stepwise. For example, after treatment is performed at 200°C for 30 minutes, the temperature is raised to 260°C, and then treatment is performed at 260°C for 1 hour. In order to obtain higher heat resistance, after heat treatment is performed at 270°C which is below the melting point of PPS, heat treatment is performed at 300°C or less, for example, at 285°C, and then is performed at 300°C or more, for example, at 310°C. In such a multi-step heat treatment, it is possible to reduce the heat shrinkage of the film in the broader temperature range. Additionally, a stepwise heat treatment, in which after treatment at high temperatures is performed, the temperature is decreased and then heat treatment is performed, may be acceptable.

With respect to the heating atmosphere, heat treatment may be performed in ordinary air, in air containing ozone, or in an inert gas atmosphere, such as in nitrogen. However, if a PPS film heat-treated includes a non-oriented film only, the film elongates and deforms due to heat treatment, and it may be difficult to obtain a film having uniform appearance and satisfactory surface flatness, and also the resultant film may become too brittle for practical use. Therefore, by using an oriented PPS film, specifically, by using a polyphenylene sulfide film which is biaxially oriented in the longitudinal direction and/or in the transverse direction in a balanced manner, heating, cross-linking, and crystallizing treatment is performed preferably, at 200 to 350°C, which is in the vicinity of the melting point, for 5 minutes to 10 hours, and thus the special polyphenylene sulfide film of the present invention can be obtained.

That is, the PPS film before being cross-linked by heating is at least uniaxially oriented, and preferably is biaxially oriented. Such a biaxially oriented PPS film is commercially available. Examples thereof include a PPS film "Torelina" (trade name) manufactured by Toray Industries, Inc. Although a biaxially oriented film only may be heat-treated, the surface flatness is easily degraded due to heat shrinkage. Therefore, a PPS film in which a non-oriented PPS film is provided with an oriented PPS film on at least one surface thereof, specifically, provided with a film which is biaxially oriented in the longitudinal direction and/or in the transverse direction in a balanced manner, is heat-treated in ordinary air, in air containing ozone, or in an inert gas atmosphere, at 200 to 350°C for 5 minutes to 10 hours, and thus the PPS film of the present invention is advantageously obtained.

The heat treatment may be performed continuously and may be performed batch process using a roll or a pile of many cut sheets. In order to decrease heat shrinkage, it is effective to freely shrink the film by heat treatment, and preferably, a film in the form of a pile of many cut sheets is heat-treated in an unrestricted state in the longitudinal direction and/or in the transverse direction. Furthermore, at this stage, by performing heat treatment while applying a pressure of 100 Pa or more to the surface of the film, satisfactory surface flatness can be maintained. By using a laminated film including a non-oriented PPS film and a biaxially oriented PPS film, it is possible to obtain a film having more satisfactory surface flatness.

Although the heat treatment may be performed in air or in an inert gas atmosphere as described above, heat treatment may be performed after cross-linking treatment is performed using radiation or peracetic acid. In the present invention, relaxation treatment may be further performed after the heat treatment. The relaxation treatment can be performed using a film in the form of a roll or a pile of cut sheets, preferably at 150 to 280°C for 1 minute to 24 hours.

A PPS film of the present invention is particularly suitable for use as a substrate of a circuit board. A circuit board of the present invention includes the PPS film described above provided with an electrical circuit at least one surface thereof. An electrical circuit is a patterned conductor through which electricity flows, and as the conductor, a metal, such as copper or aluminum, or a conductive paint containing copper, silver, or carbon is generally used. The electrical circuit may be mounted with electrical components and electronic components. The circuit boards may be multi-layered. In such a circuit board, holes are easily formed by a drill, a laser, a melting penetration method, or the like. In order to fabricate a circuit, a method in which a photosensitive resin is applied to a metallic foil attached to a PPS film, after a circuit pattern is printed by light, the resin in the unexposed portions is removed, and then etching is performed using a ferric chloride solution if the metallic foil is made of copper, a method in which a circuit pattern is formed by pressing a PPS film with a mold provided with the circuit pattern, and a conductive paint is poured into the circuit portion, or the like may be used. Since the PPS film of the present invention has particularly superior dimensional stability to heat, the film is suitable for use in a method for forming circuits by press molding.

Although the circuit board using the PPS film in the present invention can be used for circuit boards in general, the circuit board of the present invention is more preferably used as an interposer in a semiconductor device, in which a finer circuit pattern is required.

Next, with respect to the polyphenylene sulfide film having a high heat distortion temperature in the present invention, a method for producing the film will be described in detail below. However, it is to be understood that the present invention is not limited thereto.

First, a liner PPS resin which is produced in the conventional method may be used, and for example, sodium sulfide and p-dichlorobenzene are reacted with each other in an amide-based polar solvent, such as N-methyl-2-pyrrolidone (NMP) in the high temperature, high pressure conditions. If necessary, a copolymer ingredient, such as trihalobenzene, may be included therein. Potassium hydroxide, a carboxylic acid alkaline metal salt, or the like is added thereto as a polymerization adjuster, and polymerization is carried out at 230 to 280 °C. The resultant polymer is cooled and formed into aqueous slurry, followed by filtering, to obtain polymer particles. The polymer particles are stirred in an acetate solution or the like, at 30 to 100°C for 10 to 60 minutes, and washing with ion-exchanged water at 30 to 80°C and drying are repeated several times to obtain powdered PPS. The powdered polymer is washed under an oxygen partial pressure of preferably 1,300 Pa or less, more preferably, 670 Pa or less, using NMP, and then washing is performed several times with ion-exchanged water at 30 to 80°C, followed by drying at a reduced pressure of 670 Pa or less.

The polymer thus obtained is a substantially linear PPS polymer, and since the PPS resin has a melt crystallization temperature $T_{mc}$ in the range of 160 to 190°C, it is possible to perform stable orientation of films.

Of course, as necessary, other polymeric compounds, inorganic compounds and organic compounds, such as silicon oxides, magnesium oxide, calcium carbonate, titanium oxides, aluminum oxide, cross-linking polyesters, cross-linking polystyrenes, mica, talc, and kaolin, thermal decomposition inhibitors, heat stabilizers, antioxidants, etc., may be added thereto.

The PPS material thus obtained is fed to a known extruder and is melted under a low-pressure atmosphere with the low oxygen content, the molten resin is extruded while being filtered with an appropriate filter, such as a sintered metal, a porous ceramic, sand, or wire netting. The extruded material is measured by a gear pump, and is discharged through a die nozzle, followed by quenching while being solidified in cold contact with a cooling medium, such as a drum, by a known contact method, such as electro-pinning, an air chamber method, an air knife method, or a press roll method, and thus a non-oriented, amorphous film is obtained.

The film is brought into contact with a heated roll and heated to 90 to 130°C, and is stretched in the longitudinal direction at a stretching ratio of 2.5 to 4 times, followed by cooling, and then the film is stretched in the transverse direction at 100 to 160°C at a stretching ratio of 2 to 4 times with the edges of the film being held by clips of a tenter. Heat treatment is then performed at 200 to 280°C for 10 to 100 seconds, and thus a biaxially oriented PPS film is obtained. Herein, the stretching method is not specifically limited, and a sequential biaxial orientation method or a simultaneous biaxial orientation method may be used. With respect to the method for driving the clips for holding the film, a screw type, a pantograph type, or a linear motor type may be used, and in particular, the driving method using a linear motor is preferably used because stretching is easily controlled. The method for producing the PPS film described above is mentioned in Japanese Examined Patent Application Publication No. 63-12772, etc.

The biaxially oriented PPS film thus obtained, having a heat distortion temperature of approximately 90°C and crystals with a heat of fusion $\Delta H_1$ of approximately 38 J/g, is heated, in one step or stepwise, at 200 to 350°C, which is close to the melting point of the PPS film, in air or in an inert gas atmosphere, and heat treatment is performed for 5 minutes to 10 hours in the above temperature range, and then relaxation treatment is performed at 150 to 280°C for 1 minute to 24 hours. Thus, a polyphenylene sulfide (PPS) film in accordance with the present invention having crystals with a heat of fusion $\Delta H_2$ of 30 J/g or less, a heat distortion temperature of 200°C or more, and a heat shrinkage of 0.05% or less at 200°C over 5 minutes can be obtained.

In order to provide a metallic layer on the PPS film, a metallic foil is overlaid on the surface of the PPS film, and thermal bonding is performed at a temperature of 200 to 300°C, preferably, in the range from ($T_{mk}$ - 30°C) to ($T_{mk}$ + 50°C), where $T_{mk}$ is a melting point of the PPS film, and at a pressure of 0.1 to 3 MPa. Alternatively, a metallic layer may be provided on the surface of the PPS film by vapor deposition, sputtering, plating, using an adhesive, or the like.

By forming a desired circuit pattern by etching (for example, with a ferric chloride solution) the metallic layer on the PPS film, a circuit board can be obtained. A circuit board in which an electrical circuit is provided on each surface of a PPS film of the present invention may be further laminated on another substrate or the like with the PPS film therebetween. Furthermore, the circuit board may be combined with a circuit board on which an electrical circuit is provided by silk-printing of a conductive paste or the like, followed by thermal bonding under the conditions described above, to form a multi-layered circuit board. The multi-layered circuit board may be provided with through-holes. The through-holes may be formed by a drill, a laser, a melting penetration method, or the like. The individual layers may be interconnected by plating or the like. As necessary, electrical components, etc. are mounted on the circuit board.

The present invention will now be described by way of examples. It should be noted, however, that the invention defined in the appended claims is not restricted to the examples below.

METHODS OF MEASURING PHYSICAL PROPERTIES

The methods of measuring various physical properties used in the present invention will be described below.

1. Heat Distortion Temperature (°C)

A thermal-mechanical analysis (TMA) was used, in which when a sample was heated, the amount of distortion relative to temperature measured was plotted, -and a temperature at which the differential curve of the amount of distortion greatly changed was defined as a heat distortion temperature. Additionally, the TMA was conducted by a thermal analysis station (MTS-9000) manufactured by Shinku-Riko, Inc. A sample with a width of 4 mm and a length of 15 mm was used and a tensile load of 16.2 g/unit cross section ($mm^2$) of the sample was applied to measure the heat distortion temperature.

2. Thickness Unevenness (%)

A film thickness tester KG 601A and an electronic micrometer K306C manufactured by Anritsu Corp. were used, and samples of 30 mm wide and 40 m long were formed from the film, and the thickness thereof was continuously measured. A variation R was calculated by subtracting a minimum thickness THIN (μm) from a maximum thickness $T_{MAX}$ (μm), and a thickness unevenness (%) was obtained from an average thickness $T_{AVE}$ (μm) according to the equation, Thickness Unevenness (%) = $R/T_{AVE} \times 100$.

3. Surface Roughness (μm)

Maximum surface roughness Ry was determined according to JIS B0601 at room temperature, with a measuring length of 2 mm, and at a cut-off of 0.25 mm. A three-dimensional surface roughness tester manufactured by Kosaka Laboratory Ltd. was used as a measuring device.

4. Adhesiveness

Aluminum was vapor-deposited on the surface of a film at a thickness of 200 angstroms, and 90 crosscuts of 1 mm square were made in the vapor-deposited layer. A cellophane adhesive tape manufactured by Nichiban Co., Ltd. was applied onto the crosscuts of the vapor-deposited layer, and was strongly pressed with fingers, and then the tape was detached from the layer in the direction of 180° . The number of remaining crosscuts was evaluated as follows.

O: 70 crosscuts or more
∆: 50 crosscuts to less than 70 crosscuts
✕: less than 50 crosscuts

5. Mechanical properties

The tensile strength and elongation of the film were determined according to JIS K7127, and the elastic modulus (Young's modulus) was determined according to JIS Z1702, using an Instron-type tensile test machine in an atmosphere of 25°C and 65%RH.

6. Coefficient α of Thermal Expansion ($\times 10^{-6}$/°C)

Samples of 5 mm wide were cut out, and each sample was clamped by a constant-load elongation test machine manufactured by Nippon Jido Seigyo Co., Ltd. which was set in a thermo-hygrostat oven (PKL-50D manufactured by Daiei Kagaku Co., Ltd.) so that a distance L between chucks was set at 150 mm, and the temperature was increased from 30 to 150°C at a rate of 2°C/min in an atmosphere of 65%RH. Based on the average gradient of variation in the range of 30°C to 150°C ($\Delta = 120$°C), the coefficient α of thermal expansion was determined according to ASTM D696, i.e., according to the equation below.

$$\alpha = (\Delta L/L)/\Delta°C$$

Unit in $10^{-6}$/°C

7. Coefficient β of Hygroscopic Expansion ($\times 10^{-6}$/%RH)

Samples of 10 mm wide were cut out, and each sample was clamped by a constant-load elongation test machine manufactured by Nippon Jido Seigyo Co., Ltd. which was set in a thermo-hygrostat oven (PKL-50D manufactured by Daiei Kagaku Co., Ltd.) so that a distance L between chucks was set at 150 mm, and the humidity was increased from 5%RH to 85%RH at 25°C ($\Delta$RH = 80%RH)). Based on the variation $\Delta$L, the coefficient β of hygroscopic expansion was obtained according to the equation below.

$$\beta = (\Delta L/L)/\Delta\%RH$$

Unit: $10^{-6}$/%RH

8. Soldering Heat Resistance (°C)

According to JIS C5013, a sample was immersed in a soldering bath, and the maximum temperature at which the appearance of the sample did not change was determined. The higher temperature indicates more superior soldering heat resistance.

9. Wetting Surface Tension γ (dyn/cm)

The wetting surface tension was determined according to JIS K-6788.

10. Heat Shrinkage (%)

By setting a certain direction of a film as a standard direction (e.g., the longitudinal direction of the film), a test sample was cut at a dimension of 100 mm $\times$ 10 mm, in the standard direction and in a direction orthogonal thereto, respectively, and marks were put thereon. A distance between the marks was accurately measured by a microscope ($\times$ mm). Next, after the sample was subjected to aging for 5 minutes in a furnace (hot gas type), which was heated to 200°C, the distance was accurately measured again (y mm). The heat shrinkage (%) was obtained according to the equation below in each direction, and the heat shrinkage of the direction which had a larger value was selected.,

$$\text{Heat shrinkage (\%)} = (x - y)/x \times 100$$

11. Dimensional change rate when the temperature is increased from room temperature to 200°C, and then is decreased to room temperature

A thermal-mechanical analysis (TMA) was carried out using TMA/SS6100 manufactured by Seiko Instruments Inc. A test sample with a width of 4 mm and an initial length of 15 mm was heated from room temperature to 200°C, under a load of 4.67 g/mm$^2$ and at a heating rate of 20°C/minute, and then was cooled to room temperature under the same conditions, the amount of dimensional change was divided by the initial length, and the resultant value was shown in percentage.

12. Thermal Characteristics

Using an RDC-220 Robot DSC manufactured by Seiko Electronics Inc. as a differential scanning calorimeter, and a disk session SSC/5200 manufactured by the same company as a data analyzer, the endothermic peak ($T_{meta}$) of the 5mg sample was measured while the temperature was increased from room temperature to 350°C at a heating rate of 20°C/minute. The sample was then recovered into air and was quenched, and when the temperature was increased again from room temperature to 350°C at a heating rate of 20°C/minute, the endothermic peak area appearing at this stage in which crystals were melted was obtained. In the case of a laminated film, the heat of fusion of the entire laminated film was obtained.

13. Thermal Bonding Characteristics

A rolled copper foil with a thickness of 35 µm was bonded onto the surface of each sample, and the state in which the resultant laminated sheet was folded was evaluated as follows.

○: No separation was observed in the folded section.
Δ: Separation occurred in less than 30% of the folded section.
×: Separation occurred in 30% or more of the folded section.

14. Surface flatness

Samples of 150 mm square which were cut out from the film parallel to both the longitudinal direction and to the transverse direction were placed in parallel on a planar table, and the height of floating of the film from the table was measured. The measured results were classified into the following 4 ranks.

⊙: less than 2 mm
○: 2 mm to less than 3 mm
Δ: 3 mm to less than 5 mm
×: 5 mm or more

EXAMPLE 1

To a linear PPS resin (Ryton T1881) manufactured by Toray Industries, Inc., 0.12% by weight of SYLOID and 0.05% by weight of calcium stearate were added as additives, and the mixture was fed into a known single screw extruder having a cylinder diameter of 150 mm, and was melted at 310°C. The melted resin was filtered through a filter box for blocking foreign matter of 10 µm or more, and was extruded from a T die nozzle having a lip width of 1,200 mm and die openings of 1.5 mm to form a film.

The extruded molten film was solidified in cold contact with a casting drum (with a diameter of 800 mm), of which surface temperature was 25°C, while the film was being applied with static electricity. The resultant cast film was an amorphous, non-oriented film.

The film was fed to a longitudinal stretching apparatus comprising a plurality of heating rolls and was stretched at a stretching ratio of 3.6 times at a film temperature of 100°C, and then the film was stretched in the transverse direction using a tenter at a stretching ratio of 3.5 times at 100°C. Heat treatment was further performed at 270°C for 15 seconds, and edges of the film were cut, and thus a biaxially oriented film having a thickness of 50 µm was obtained. This film had a heat distortion temperature of 89°C.

The resultant biaxially oriented PPS film was continuously heat-treated in air for 10 minutes in an oven heated to 280°C, and then was further continuously heat-treated for 5 minutes in an oven heated to 310°C.

The film thus obtained had satisfactory surface flatness and a high degree of gloss although the film was colored in brown. The characteristics of the film were as follows.

| | |
|---|---|
| Heat distortion temperature | 320°C |
| Coefficient $\alpha$ of thermal expansion | 13 ($\times$ 10$^{-6}$/°C) |
| Coefficient $\beta$ of hygroscopic expansion | 3 ($\times$ 10$^{-6}$/%RH) |
| Soldering heat resistance | 330°C or more |
| Wetting surface tension $\gamma$ | 61 dyn/cm |

(continued)

| Surface roughness Ry | 0.13 μm |
|---|---|
| Thickness unevenness in the longitudinal direction | 6% |
| Adhesiveness | O (satisfactory) |
| Heat shrinkage (250°C) | 1% |
| Breaking elongation | 40% |

As is clear from the above, the film which is merely biaxially oriented has a low heat distortion temperature of 89°C, and the film cannot be used as a film for IC substrates. However, by performing multi-step heating, cross-linking treatment in an oxygen atmosphere for a long period of time, it is possible to obtain a film having superior heat resistance of the present invention.

EXAMPLES 2 to 4, and COMPARATIVE EXAMPLES 1 to 3

By varying the heat-treating temperatures in the first and second heat-treating steps, continuous heat treatment was performed in a heated oven, and samples with various heat distortion temperatures were prepared.
The results thereof are shown in Table 1.

TABLE 1

| | First Heat-treating Temperature (°C) | Second Heat-treating Temperature (°C) | Heat Distortion Temperature (°C) | Coefficient $\alpha$ of thermal expansion ($\times$ $10^{-6}$/°C) |
|---|---|---|---|---|
| Example 1 | 280 | 310 | 320 | 13 |
| Example 2 | 280 | 280 | 300 | 16 |
| Example 3 | 280 | Not performed | 280 | 19 |
| Example 4 | 250 | Not performed | 245 | 24 |
| Comparative Example 1 | 200 | Not performed | 190 | 33 |
| Comparative Example 2 | 180 | Not performed | 155 | 38 |
| Comparative Example 3 | Not performed | Not performed | 89 | 45 |

As is clear from the above table, the heat distortion temperature and the coefficient of thermal expansion greatly vary depending on the heat-treating conditions.
In particular, with respect to the polyphenylene sulfide films in Examples 1 to 4, the coefficient $\alpha$ of thermal expansion is below 10 to 25 ($\times$ $10^{-6}$/°C) and also below 30 ($\times$ $10^{-6}$/°C), and thus the heat resistance is satisfactory.
Since a copper foil has a coefficient of thermal expansion of approximately 20 ($\times$ $10^{-6}$/°C), if a film having substantially the same coefficient of thermal expansion as that of the copper foil is used, curling does not easily occur when the film and the copper foil are laminated to each other, and a film which is heat-treated at approximately 280°C is suitable for use in a laminate with a copper foil.

EXAMPLE 5

Using a non-oriented, amorphous film before stretching used in Example 1, heating, cross-linking treatment was performed in a manner similar to that in Example 1.
That is, without performing biaxial orientation, the non-oriented film was continuously heat-treated in air for 30 minutes in an oven heated to 280°C to introduce a cross-linking structure. The film thus obtained was colored in brown. The characteristics of the film were as follows.

| Heat distortion temperature | 275°C |
|---|---|
| Coefficient $\alpha$ of thermal expansion | 26 ($\times$ $10^{-6}$/°C) |

(continued)

| Coefficient β of hygroscopic expansion | 6 ($\times$ 10$^{-6}$/%RH) |
| Soldering heat resistance | 255°C or more |
| Wetting surface tension γ | 61 dyn/cm |
| Surface roughness Ry | 0.23 μm |
| Breaking elongation | 13% |

The polyphenylene sulfide film of the present invention thus obtained had high heat resistance. However, since this film was relatively brittle with a breaking elongation of approximately 13%, the film was assumed to be suitable for use as a heat-resistant sheet for a thick member.

When the film was bonded to copper and experimentally used as an interposer, the resultant product had satisfactory heat resistance and electrical characteristics. Since the film had satisfactory heat-resisting properties, even if the film was thinner than a conventional heat-resistant film, the desired objective was achieved, and it was possible to make the size of the interposer more compact.

EXAMPLE 6

To a linear PPS resin (Ryton T1881) manufactured by Toray Industries, Inc., 0.12% by weight of SYLOID and 0.05% by weight of calcium stearate were added as additives, and the mixture was fed into a known single screw extruder having a cylinder diameter of 150 mm, and was melted at 310°C. The molten resin was filtered through a filter box for blocking foreign matter of 10 μm or more, and was extruded from a T die nozzle having a lip width of 1,200 mm and die openings of 1.5 mm to form a film.

The extruded molten film was solidified in cold contact with a casting drum (with a diameter of 800 mm), of which surface temperature was 25°C, while the film was being applied with static electricity. The resultant cast film was an amorphous, non-oriented film.

The film was fed to a longitudinal stretching apparatus comprising a plurality of heating rolls and was stretched at a stretching ratio of 3.6 times at a film temperature of 100°C, and then the film was stretched in the transverse direction using a tenter at a stretching ratio of 3.5 times at 100°C. Heat treatment was further performed at 270°C for 15 seconds and the film was relaxed by 8% in the direction of tenter width, and then edges of the film were cut, and thus a biaxially oriented film having a thickness of 50 μm was obtained. When this film was measured by DSC, the crystals had a heat of fusion $\Delta H_1$ of 39 J/g.

The resultant biaxially oriented film, as a sample in the form of a roll, was continuously heat-treated in air for 2 hours in an oven heated to 280°C, and then was further continuously heat-treated for 2 hours in an oven heated to 290°C. Next, relaxation treatment was performed without strain at a temperature of 200°C. With respect to the film thus obtained, it was found from the DSC curve that the endothermic peak $T_{meta}$ was 210°C and the crystals had a heat of fusion $\Delta H_2$ of 29 J/g, and although the film was colored in brown, the soldering heat resistance was 294°C. The dimensional change rate at room temperature measured by TMA was 0.05%, the surface flatness was satisfactory at O, and the degree of gloss on the surface was high. The characteristics are shown in Tables 2 and 3 below..

Next, to the PPS film thus obtained having a thickness of 50 μm, 1 ounce (36 μm thick) of rolled copper foil was thermally bonded. The thermal bonding was performed by a hot-plate press method, at 300°C, and at a pressure of 1 MPa, and the pressing period was set at 1 hour, and the quenching was performed to 50°C in a pressed state. Next, the copper foil was etched to form an electrical circuit using a ferric chloride solution, and thus a circuit board was obtained.

The circuit board thus obtained exhibited satisfactory thermal bonding properties to the copper foil. The results thereof are shown in Tables 2 and 3 below.

EXAMPLE 7

A biaxially oriented PPS film obtained in Example 6 was placed on each surface of a non-oriented PPS film before stretching which was cast in a manner similar to that in Example 6, and lamination was performed by hot-plate pressing at a temperature of 260°C and at a pressure of 1 MPa. The biaxially oriented PPS film on either side had a thickness of 50 μm, and the non-oriented PPS film had a thickness of 200 μm. The resultant laminated film was heat-treated in the same manner as that in Example 6. In the laminated film comprising the biaxially oriented PPS layer, the non-oriented PPS layer, and the biaxially oriented PPS layer, the endothermic peak $T_{meta}$ in the DSC curve was 212°C, and although the film was colored in brown, the soldering heat resistance was 289°C. The dimensional change rate at room temperature measured by TMA was 0.25%, the surface flatness was excellent at ⊙, and the film was flexible. The characteristics of this laminated film are shown in Tables 2 and 3.

Next, to the laminated PPS film, a rolled copper foil was thermally bonded in a manner similar to that in Example 6, and the copper foil was etched to form an electrical circuit pattern, using a ferric chloride solution, and thus a circuit board was obtained. The circuit board thus obtained exhibited satisfactory thermal bonding properties to the copper foil. The results thereof are shown in Tables 2 and 3.

EXAMPLE 8

A biaxially oriented PPS film obtained in a manner similar to that in Example 6 was heat-treated for 1 hour without strain at a temperature of 200°C, and then was further heat-treated for 1 hour without strain at 260°C. In the resultant film, the endothermic peaks $T_{meta}$ in the DSC curve were 210°C and 265°C, and although the film was colored in brown, the soldering heat resistance was 260°C. The dimensional change rate at room temperature measured by TMA was 0.03%, the surface flatness was satisfactory at O, and the degree of gloss on the surface was high. The characteristics are shown in Tables 2 and 3 below.

To the PPS film thus obtained, a rolled copper foil was thermally bonded in a manner similar to that in Example 6, and the copper foil was etched to form an electrical circuit pattern, using a ferric chloride solution, and thus a circuit board was obtained. The resultant circuit board exhibited satisfactory thermal bonding properties to the copper foil. The results thereof are shown in Tables 2 and 3.

EXAMPLE 9

A biaxially oriented PPS film obtained in Example 6 was placed on each surface of a non-oriented PPS film before stretching, cast by the same manner as that in Example 6, and roll pressing was performed at a temperature of 260°C and at a linear pressure of 20 kg/cm. In the resultant laminated PPS film, the biaxially oriented film on either surface had a thickness of 50 µm and the non-oriented PPS film had a thickness of 200 µm. A piece of 50 cm square was cut out from the laminated PPS film, and was sandwiched between iron plates. The laminated PPS film was applied with a planar pressure of 300 Pa due to the weight of the iron plates. Additionally, the transverse direction and the longitudinal direction of the film were not restricted, and the film could shrink freely. In such a state, heat treatment was performed for 1 hour in a hot-gas oven at 200°C, and then the temperature of the hot-gas oven was increased to 260°C, followed by heat treatment for 1 hour. After the heat treatment, cooling was performed to 30°C over 4 hours, and samples were obtained. In the resultant film, the endothermic peaks $T_{meta}$ in the DSC curve were 212°C and 266°C, and although the film was colored in brown, the soldering heat resistance was 260°C. The dimensional change rate at room temperature measured by TMA was 0.01%, the surface flatness was excellent at ⊙, and the film had a high degree of gloss on the surface. The characteristics of the film are shown in Tables 2 and 3.

To the PPS film thus obtained, a rolled copper foil was thermally bonded in a manner similar to that in Example 6, and the copper foil was etched to form an electrical circuit pattern, using a ferric chloride solution, and thus a circuit board was obtained. The resultant circuit board exhibited satisfactory thermal bonding properties to the copper foil. The results thereof are shown in Tables 2 and 3.

COMPARATIVE EXAMPLE 4

To a biaxially oriented PPS film obtained in Example 6 which was not heat-treated, a rolled copper foil was thermally bonded in a manner similar to that in Example 6, and the copper foil was etched with a ferric chloride solution to form an electrical circuit pattern, and thus a circuit board was obtained.

When the biaxially oriented PPS film which was not heat-treated was floated in a soldering bath, at 240°C or more, the film was deformed, and the surface flatness was degraded. The endothermic peak $T_{meta}$ in the DSC curve was 255°C, and the dimensional change rate at room temperature measured by TMA was 3.0%. With respect to a circuit board fabricated using the biaxially oriented PPS film which was not cross-linked, when a rolled copper foil was thermally bonded, the biaxially oriented PPS film was thermally deformed, and thus it was not possible to perform satisfactory bonding to the rolled copper foil. The characteristics of the biaxially oriented PPS film and the thermal bonding properties to the copper foil are shown in Tables 2 and 3.

TABLE 2

| | Soldering Heat Resistance (°C) | Heat Shrinkage (%) (200°C, 5 min) | | Room Temperature to 200°C to Room Temperature Dimensional Change Rate (%) | $T_{meta}$ (°C) |
|---|---|---|---|---|---|
| | | MD | TD | | |
| Example 6 | 294 | 0.03 | 0.04 | 0.05 | 210 |
| Example 7 | 289 | 0.04 | 0.05 | 0.25 | 212 |
| Example 8 | 260 | 0.02 | 0.04 | 0.03 | 210, 265 |
| Example 9 | 260 | 0.02 | 0.03 | 0.01 | 212, 266 |
| Comparative Example 4 | 240 | 0.63 | 3.50 | 3.0 | 255 |

MD means longitudinal direction.

TD means transverse direction.

TABLE 3

| | Ratio of Heat of fusion $\Delta H_2/\Delta H$ | Coefficient $\beta$ of Hygroscopic Expansion ($\times 10^{-6}$/ %RH) | Thermal Bonding Properties | Surface flatness |
|---|---|---|---|---|
| Example 6 | 0.74 | 1.8/1.9 | O | O |
| Example 7 | 0.7 | 2.0/2.0 | O | ⊙ |
| Example 8 | 0.6 | 1.9/1.9 | O | O |
| Example 9 | 0.7 | 1.8/1.8 | O | ⊙ |
| Comparative Example 4 | 1.0 | 2.0/2.0 | Δ | - |

**Claims**

1. A polyphenylene sulfide film having a heat distortion temperature of 200°C or more.

2. A polyphenylene sulfide film according to Claim 1, wherein the heat distortion temperature is 260°C or more.

3. A polyphenylene sulfide film according to one of Claims 1 and 2, wherein the coefficient $\alpha$ of thermal expansion is 30 ($\times 10^{-6}$/°C) or less.

4. A polyphenylene sulfide film according to any one of Claims 1 to 3, wherein the coefficient $\beta$ of hygroscopic expansion is 10 ($\times 10^{-6}$/%RH) or less.

5. A polyphenylene sulfide film according to any one of Claims 1 to 4, wherein the soldering heat resistance is 250°C or more.

6. A polyphenylene sulfide film according to Claim 5, wherein the soldering heat resistance is 260°C or more.

7. A polyphenylene sulfide film having a heat shrinkage of 0.05% or less at 200°C over 5 minutes in all directions in the film.

8. A polyphenylene sulfide film according to any one of Claims 1 to 6, wherein the heat shrinkage is 0.05% or less at 200°C over 5 minutes in all directions in the film.

9. A polyphenylene sulfide film according to any one of Claims 1 to 8, wherein the dimensional change rate at room temperature is 1% or less in all directions in the film when the temperature is increased from room temperature to 200°C and is then decreased to room temperature.

10. A polyphenylene sulfide film according to Claim 9, wherein the dimensional change rate is 0.3% or less in all directions in the film.

11. A polyphenylene sulfide film according to any one of Claims 1 to 10, wherein the endothermic peak ($T_{meta}$) appearing before crystalline melting according to differential scanning calorimetry (DSC) is in the range from the melting point ($T_m$) to ($T_m$ - 80)°C.

12. A polyphenylene sulfide film according to any one of Claims 1 to 11, wherein two or more endothermic peaks ($T_{meta}$) are present.

13. A polyphenylene sulfide film according to any one of Claims 1 to 12, wherein the polyphenylene sulfide film is a multi-layered film comprising polyphenylene sulfide films having the same degree or different degrees of orientation.

14. A polyphenylene sulfide film according to Claim 13, wherein the polyphenylene sulfide film comprises a non-oriented polyphenylene sulfide film laminated at least on one surface of a biaxially oriented polyphenylene sulfide film.

15. A polyphenylene sulfide film according to Claim 14, wherein the thickness of the non-oriented polyphenylene sulfide film is 20 to 90% of the thickness of the overall film.

16. A circuit board comprising a polyphenylene sulfide film according to any one of Claims 1 to 15 provided with an electrical circuit at least on one surface thereof.

17. A circuit board according to Claim 16, wherein the circuit board is used as an interposer in a semiconductor device.

18. A method for producing a polyphenylene sulfide film comprising the step of heat-treating a polyphenylene sulfide film having a heat distortion temperature of 150°C or less so as to increase the heat distortion temperature to 200°C or more.

19. A method for producing a polyphenylene sulfide film comprising the step of heat-treating a polyphenylene sulfide film comprising a single layer or multiple layers in the temperature range of 200°C to 350°C for 5 minutes to 10 hours.

20. A method for producing a polyphenylene sulfide film according to one of Claims 18 and 19, wherein heat-treating is performed by increasing the temperature stepwise.

21. A method for producing a polyphenylene sulfide film according to any one of Claims 18 to 20, wherein the polyphenylene sulfide film is in the form of a pile of cut sheets and the film is heat-treated in an unrestricted state in the longitudinal direction and/or in the transverse direction.

22. A method for producing a polyphenylene sulfide film according to any one of Claims 18 to 21, wherein heat-treating is performed while applying a pressure of 100 Pa or more to the surface of the film.

23. A method for producing a polyphenylene sulfide film according to any one of Claims 18 to 22, wherein a polyphenylene sulfide film which is biaxially oriented in the longitudinal direction and the transverse direction is heat-treated.

**European Patent Office**

## EUROPEAN SEARCH REPORT

Application Number

EP 01 10 1381

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 233 494 A (KUREHA CHEMICAL IND CO LTD) 26 August 1987 (1987-08-26) * table 2 * | 1-12,18, 19 | C08J5/18 C08G75/02 |
| X | FR 2 500 841 A (TORAY INDUSTRIES) 3 September 1982 (1982-09-03) * examples A-1-3; table 3 * | 1-12,18, 19 | |
| X | EP 0 358 135 A (IDEMITSU KOSAN CO) 14 March 1990 (1990-03-14) * page 10; table 1 * * page 6, line 49 - line 50 * | 1-12,18, 19 | |
| X | EP 0 308 192 A (KUREHA CHEMICAL IND CO LTD) 22 March 1989 (1989-03-22) * claims 1,5 * | 1-12 | |
| X | EP 0 367 469 A (KUREHA CHEMICAL IND CO LTD) 9 May 1990 (1990-05-09) * claim 12; example 12 * | 1-12 | |
| A | US 5 223 585 A (MIZUNO TOSHIYA ET AL) 29 June 1993 (1993-06-29) * claims 1-3 * | 1-23 | TECHNICAL FIELDS SEARCHED (Int.Cl.7) C08J C08G |
| A | PATENT ABSTRACTS OF JAPAN vol. 013, no. 510 (C-654), 15 November 1989 (1989-11-15) & JP 01 204933 A (TORAY IND INC), 17 August 1989 (1989-08-17) * abstract * | 1-23 | |

The present search report has been drawn up for all claims

| Place of search | Date of completion of the search | Examiner |
|---|---|---|
| THE HAGUE | 21 May 2001 | O'Sullivan, T |

EPO FORM 1503 03.82 (P04C01)

**ANNEX TO THE EUROPEAN SEARCH REPORT
ON EUROPEAN PATENT APPLICATION NO.**                    EP 01 10 1381

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2001

| Patent document cited in search report | | Publication date | Patent family member(s) | | Publication date |
|---|---|---|---|---|---|
| EP 0233494 | A | 26-08-1987 | JP | 1807925 C | 10-12-1993 |
| | | | JP | 5012377 B | 17-02-1993 |
| | | | JP | 62172033 A | 29-07-1987 |
| | | | JP | 1981014 C | 17-10-1995 |
| | | | JP | 7008545 B | 01-02-1995 |
| | | | JP | 63149132 A | 21-06-1988 |
| FR 2500841 | A | 03-09-1982 | NONE | | |
| EP 0358135 | A | 14-03-1990 | JP | 2070754 A | 09-03-1990 |
| | | | JP | 2759658 B | 28-05-1998 |
| | | | JP | 2175228 A | 06-07-1990 |
| | | | JP | 2627657 B | 09-07-1997 |
| | | | DE | 68925549 D | 14-03-1996 |
| | | | DE | 68925549 T | 20-06-1996 |
| EP 0308192 | A | 22-03-1989 | JP | 1074266 A | 20-03-1989 |
| | | | JP | 2106285 C | 06-11-1996 |
| | | | JP | 8026221 B | 13-03-1996 |
| | | | AT | 99349 T | 15-01-1994 |
| | | | DE | 3886639 D | 10-02-1994 |
| | | | DE | 3886639 T | 14-04-1994 |
| | | | ES | 2061669 T | 16-12-1994 |
| EP 0367469 | A | 09-05-1990 | JP | 2229857 A | 12-09-1990 |
| | | | US | 4975479 A | 04-12-1990 |
| | | | CA | 2001093 A,C | 25-04-1990 |
| | | | CA | 2001096 A,C | 25-04-1990 |
| | | | CA | 2001097 A,C | 25-04-1990 |
| | | | CA | 2001098 A | 25-04-1990 |
| | | | EP | 0368503 A | 16-05-1990 |
| | | | EP | 0369620 A | 23-05-1990 |
| | | | EP | 0367470 A | 09-05-1990 |
| | | | JP | 2225527 A | 07-09-1990 |
| | | | US | 5120808 A | 09-06-1992 |
| | | | US | 4960806 A | 02-10-1990 |
| | | | US | 4962143 A | 09-10-1990 |
| | | | US | 4960555 A | 02-10-1990 |
| | | | US | 4980114 A | 25-12-1990 |
| | | | US | 5153278 A | 06-10-1992 |
| | | | US | 5153264 A | 06-10-1992 |
| | | | US | 5153279 A | 06-10-1992 |
| | | | JP | 2225535 A | 07-09-1990 |
| | | | JP | 2234912 A | 18-09-1990 |
| US 5223585 | A | 29-06-1993 | JP | 1158049 A | 21-06-1989 |

EPO FORM P0459

For more details about this annex : see Official Journal of the European Patent Office, No. 12/82

**ANNEX TO THE EUROPEAN SEARCH REPORT
ON EUROPEAN PATENT APPLICATION NO.**

EP 01 10 1381

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2001

| Patent document cited in search report | Publication date | Patent family member(s) | | Publication date |
|---|---|---|---|---|
| US 5223585 A | | JP | 2031774 C | 19-03-1996 |
| | | JP | 7057819 B | 21-06-1995 |
| | | AT | 102976 T | 15-04-1994 |
| | | CA | 1317430 A | 11-05-1993 |
| | | DE | 3888487 D | 21-04-1994 |
| | | DE | 3888487 T | 30-06-1994 |
| | | EP | 0321215 A | 21-06-1989 |
| | | US | 5095078 A | 10-03-1992 |
| JP 01204933 A | 17-08-1989 | NONE | | |

For more details about this annex : see Official Journal of the European Patent Office, No. 12/82